# EUROPEAN PATENT SPECIFICATION

(11) **EP 3 966 896 B1**
(45) Date of publication and mention of the grant of the patent: **02.07.2025**
(21) Application number: 20726881.4
(22) Date of filing: 05.05.2020
(51) Int. Cl.: H01Q 1/24, H01Q 1/38, H01Q 21/06

(54) **AN ANTENNA ELEMENT AND AN ANTENNA ARRAY FOR WIRELESS COMMUNICATION SYSTEMS**
ANTENNENELEMENT UND ANTENNENANORDNUNG FÜR DRAHTLOSE KOMMUNIKATIONSSYSTEME
ÉLÉMENT D'ANTENNE ET RÉSEAU D'ANTENNES POUR SYSTÈMES DE COMMUNICATION SANS FIL

(30) Priority: 07.05.2019 FI 20195376
(43) Date of publication of application: 16.03.2022
(73) Proprietor: Teknologian tutkimuskeskus VTT Oy, 02150 Espoo (FI)
(72) Inventor: SOMERSALO, Matti, 02150 Espoo (FI)
(74) Representative: Laine IP Oy
(86) International application number: PCT/FI2020/050303
(87) International publication number: WO 2020/225482

(56) References cited:
- EP-A1- 2 779 307
- CA-A1- 2 414 124
- CA-C- 2 414 124
- DE-U1- 202017 003 830
- SE-C2- 522 829
- US-A1- 2005 062 649
- US-A1- 2008 316 117
- US-A1- 2011 095 945

## Description

### FIELD

Embodiments of the present invention relate in general to an antenna element and an antenna array for wireless communication systems.

### BACKGROUND

Performance of wireless communication systems may be enhanced by exploiting antenna arrays for transmission and/or reception over a radio channel. If antenna arrays are used for both, transmission and reception, the system may be referred to as a Multiple-Input Multiple-Output, MIMO, system. As the demand for wireless communication increases, the use of MIMO is becoming even more important than before. For example, 3rd Generation Partnership Project, 3GPP, develops 5G technology, which may be referred to as New Radio, NR, radio access technology as well, and considers the use of MIMO for that. Similar enhancements may also be employed in other cellular networks and in several other wireless communication networks as well, such as, for example, in Wireless Local Area Networks, WLANs. Therefore it is expected that the use of MIMO increases in the future. However, current antenna arrays are heavy and expensive to manufacture. There is therefore a need to provide light-weight antenna arrays that are cheap to manufacture.

US 2005/062649 A1 presents an antenna array formed on a deformable dielectric material or substrate includes a center element and plurality of radial elements extending from a center hub. In the operative mode, the radial elements are folded upwardly into an approximately vertical position, with the center element at the center of the hub and the radial elements circumferentially surrounding the center element. When not in use, the antenna elements are deformed into a plane and can therefore be integrated into a housing for compact storage.

CA 2 414 124 A1 presents an antenna with near-field radiation control. SE 522 829 C2 relates to a multi-band antenna for use in a portable telecommunications apparatus. US 2008/316117 A1 presents a handheld electronic device may be provided that contains a conductive housing and other conductive elements. DE 20 2017 003830 U1 presents an electronic device may be provided with wireless circuitry, wherein the wireless circuitry may include one or more antennas and transceiver circuitry, such as, millimeter wave transceiver circuitry, and the antennas can be organized into beam steering arrays.

### SUMMARY OF THE INVENTION

According to some aspects, there is provided the subject-matter of the independent claims. Some embodiments are defined in the dependent claims.

According to a first aspect of the present invention, there is provided an antenna element for an antenna array, comprising, a transmission line and an antenna, wherein one end of the transmission line is coupled to a base board of the antenna array and another end of the transmission line is coupled to the antenna, and a first part of the transmission line is bent about 90 degrees compared to a second part of the transmission line, and the transmission line and the antenna are on, or in, a single flexible film.

According to the first aspect of the present invention, the antenna element may further comprise at least a part of a support element between the base board of the antenna array and the antenna, wherein the transmission line may be bent along a side of the part of the support element.

According to the first aspect of the present invention, said single flexible film may be made of plastic.

According to the first aspect of the present invention, said single flexible film may comprise an opening and the transmission line is arranged to go through the opening.

According to the first aspect of the present invention, said single flexible film may be made of Polyethylene terephthalate, PET, -material.

According to the first aspect of the present invention, a thickness of the single flexible film may be about 50 micrometers or less, such as 25 micrometers.

According to the first aspect of the present invention, the antenna may be a dipole antenna.

According to the first aspect of the present invention, the antenna and the base board may be at a distance from each other, the distance preferably being comparable to a quarter of a wavelength.

According to the first aspect of the present invention, the transmission line may comprise copper or silver paste.

According to the first aspect of the present invention, the antenna element may further comprise a parasitic element in parallel with the antenna.

According to a second aspect of the present invention, an antenna array may comprise multiple antenna elements according to the first aspect.

According to a third aspect of the present invention, a wireless network node may comprise the antenna array according to second aspect. In some embodiments, the wireless network node may be a base station configured to operate in accordance with a 3rd Generation Partnership Project, 3GPP, standard. Moreover, the 3GPP standard may be a 5G standard.

### BRIEF DESCRIPTION OF THE DRAWINGS

FIGURE 1 illustrates an exemplary antenna element in accordance with at least some embodiments of the present invention;
FIGURE 2a illustrates a first example of two antenna elements in accordance with at least some embodiments of the present invention;
FIGURE 2b illustrates a second example of two antenna elements in accordance with at least some embodiments of the present invention;
FIGURE 3a illustrates a third example of two antenna elements in accordance with at least some embodiments of the present invention;
FIGURE 3b illustrates a fourth example of two antenna elements in accordance with at least some embodiments of the present invention;
FIGURE 4a illustrates a first example of an antenna array comprising 8*8 antenna elements in accordance with at least some embodiments of the present invention;
FIGURE 4b illustrates a second example of an antenna array comprising 8*8 antenna elements in accordance with at least some embodiments of the present invention.

### EMBODIMENTS

Some embodiments of the present invention relate to an antenna element for an antenna array. More specifically, a transmission line and an antenna of the antenna element may be on, or in, a single flexible film, such as a 50 or 25 micrometers thick Polyethylene terephthalate, PET, material. The transmission line, and possibly a part of the antenna, may be bent down 90 degrees towards a base board of the antenna array and coupled to the base board. Thus, one end of the transmission line may be coupled to the antenna, such as a dipole antenna or a crossed dipole, while another end of the transmission line may be coupled to the base board of the antenna array, thereby enabling the operation of the antenna element. At the same time, the antenna element and the antenna array may be light-weight and cheap to manufacture due to the use of the single flexible film.

According to some embodiments of the present invention, said one end of the transmission line may be coupled to the antenna using a solid connection, such as a galvanic connection. Similarly, said another end of the transmission line may be coupled to the base board of the antenna array using a solid connection. For instance, said another end of the transmission line may be coupled to a feed line on the base board. So according to at least some embodiments of the present invention, coupling may not be capacitive or inductive.

Embodiments of the present invention may be exploited in various wireless communication networks, such as in the context of 5G, i.e., New Radio, NR, networks and for future cellular networks as well. Embodiments of the invention are not limited to cellular networks though, and can be exploited in any wireless system.

For instance, a wireless communication network may comprise one or more wireless terminals, base stations, relay nodes and/or core network elements. A wireless terminal may be connected to a base station and/or relay node via air interface. Then, an antenna element and/or an antenna array may be used for performing wireless communications over the air interface using a Radio Access Technology, RAT. In case of cellular networks, the RAT may be for example Long Term Evolution, LTE, New Radio, NR, or MulteFire. In case of non-cellular networks, the RAT may be for example Wireless Local Area Network, WLAN.

Using NR as an example of a cellular RAT, a base station may be referred to as gNB and a wireless terminal may be referred to as a User Equipment, UE. In case of WLAN, a base station may be referred to as an access point. Generally speaking, a base station, a relay node and an access point may be referred to as wireless network nodes. In any case, embodiments of the present invention are not restricted to any particular wireless technology. Instead, embodiments of the present invention may be exploited in any wireless communication network, wherein an antenna element and/or an antenna array is used for wireless communications.

It is expected that the utilization of antenna arrays increase in various wireless communication systems. For example, massive Multiple-Input Multiple-Output, MIMO, systems may be used in 5G/NR BSs. Thus, antenna elements of the antenna arrays should be cheap to manufacture and preferably light-weight as well. Embodiments of the present invention therefore provide an antenna element for an antenna array, wherein an antenna and a transmission line of an antenna element may be manufactured on a single flexible film. The single flexible film may be thin. For instance, the single flexible film may be made of PET material. In embodiments of the present invention, thickness of the single flexible film is not crucial, but to guarantee flexibility thickness of the single flexible film may be 50 micrometers or less. For instance, thickness of 25 micrometers may be used too or any other thickness which is good for bending the transmission lines 90 degrees. The material of the single flexible film may be of any low loss RF-material, such as polyimide, yet PET film is cheap. The support material may slightly affect antenna characteristics and should be taken into account in antenna design.

An antenna element may comprise the transmission line for connecting the antenna, such as a dipole antenna, to a base board of an antenna array. In some embodiments, the transmission line may be made deploying copper etching or roll-to-roll printing of silver paste. That is to say, the transmission line may be made of copper or silver.

In some embodiments of the present invention, the transmission line may be separated partly from the single flexible film, e.g., by using a stamping tool, and then bent down 90 degrees. Thus, the transmission line may be coupled, or connected, to the antenna from one end and to the base board of the antenna array from the other end.

In some embodiments of the present invention, pair line impedance may be about 150 ohms, with a 0.2 mm gap between the base board of the antenna array and the antenna. In some embodiments, a length of the transmission line may be adjusted using a meandering line. When the length of the transmission line is 180 degrees, the antenna input impedance is back to original. Length of the transmission line is a design issue and may be chosen so that impedance matching is easy on the base board of the antenna array.

In some embodiments of the present invention, an antenna element or antenna array may need a support element between the base board of the antenna array and one or more antennas. The support element, or a part of it, may be manufactured using a 3D printer. Alternatively, the support element, or a part of it, may be shaped of light weighted bulk material (relative dielectric constant close to 1) such as Rohacell^{®}.

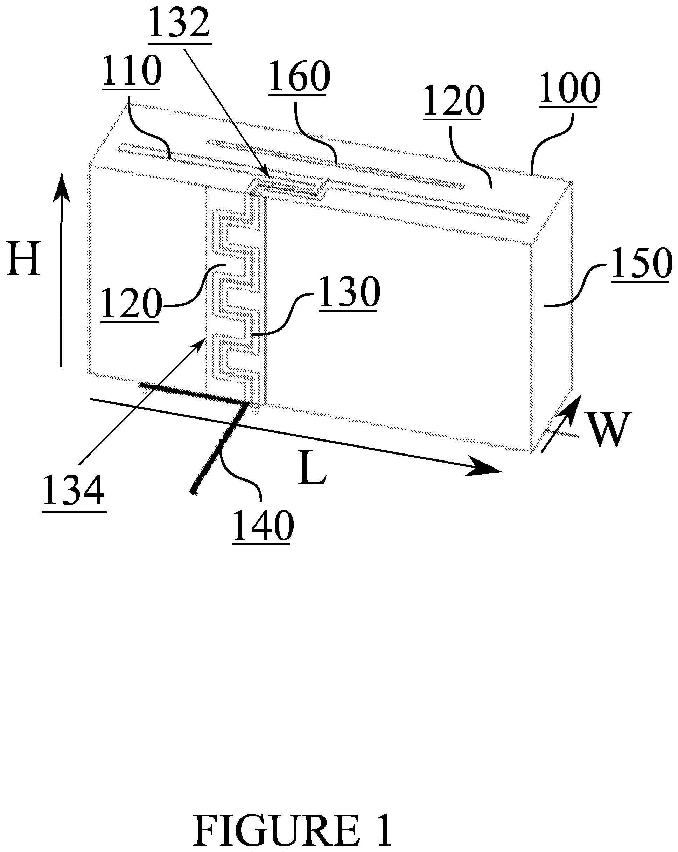

Concerning antenna elements, FIGURE 1 illustrates an exemplary antenna element in accordance with at least some embodiments of the present invention. The antenna element 100 may be for an antenna array (not shown in FIGURE 1). In some embodiments, the exemplary single antenna element 100 is linearly polarized. The exemplary antenna element 100 of FIGURE 1 may comprise an antenna 110, such as a dipole antenna, on a single flexible film 120. The antenna 110 may be above ground and above a base board of an antenna array.

The single flexible film 120 may be a plastic film, such as a PET film. In some embodiments, thickness of the single flexible film 120 may be typically 50 micrometers or less, such as 25 micrometers. The exemplary antenna element 100 of FIGURE 1 may also comprise a transmission line 130, such as a meandering line, on, or in, the single flexible film 120. The transmission line 130 may comprise a first part 132 and a second part 134. Thus, in some embodiments, the first part 132 may be on, or in, the single flexible film and the second part 134 may be on, or in, the single flexible film.

In addition, in some embodiments, the exemplary antenna element 100 of FIGURE 1 may comprise a feed with or without matching element(s) 140 and/or a support element 150, or at least a part of the support element 150. In some embodiments, the exemplary antenna 100 element of FIGURE 1 may also comprise parasitic element 160, for example in case of double band antennas or enhanced single band bandwidth. On the other hand, parasitic element 160 may not be beneficial when targeted bandwidth of single band antennas can be obtained without this element, i.e., in case of single band antenna antennas the exemplary antenna element 100 may, or may not, comprise parasitic element 160. Parasitic element 160 may for example add resonance on a higher band. Thus, parasitic element 160 is optional.

In some embodiments of the present invention, one end of the transmission line 130, such as the end associated with the second part 134 of the transmission line 130, may be coupled or connected to a base board (not shown in FIGURE 1) of the antenna array. Another end of the transmission line, such as the end associated with the first part 132 of the transmission line 130, may be coupled or connected to the antenna 110. As shown in FIGURE 1, the first part 132 of the transmission line 130 may be bent about 90 degrees compared to the second part 134 of the transmission line.

In some embodiments, the support element 150, or at least a part of the support element 150, may be between the base board of the antenna array and the antenna 110. In such a case, the transmission line 130 may be bent along a side of the support element 150, or a part of the support element 150. That is to say, the transmission line 130 may be bent over an edge of the support element 150, or a part of the support element 150.

In FIGURE 1, H denotes height of the exemplary antenna element 100, *L* denotes length of the exemplary antenna element 100 and W denotes width of the exemplary antenna element 100. As dimensions of an antenna depend on operation frequency, the dimensions may be defined using electrical dimensions, i.e., with respect to wavelengths. For instance, for a dipole antenna element on a reflective base, *L* may be close to a half of a wavelength and *H* may be close to a quarter of the wavelength at a centre frequency, for optimal bandwidth and radiation efficiency (e.g. at 3.5 GHz, *L* ~ 40 mm and *H* ~20 mm). Minimum *W* is determined by antenna (dipole) width and the possible parasitic element. Said distance may be referred to as a gap as well. In some embodiments, the gap may be filled with the support element 150.

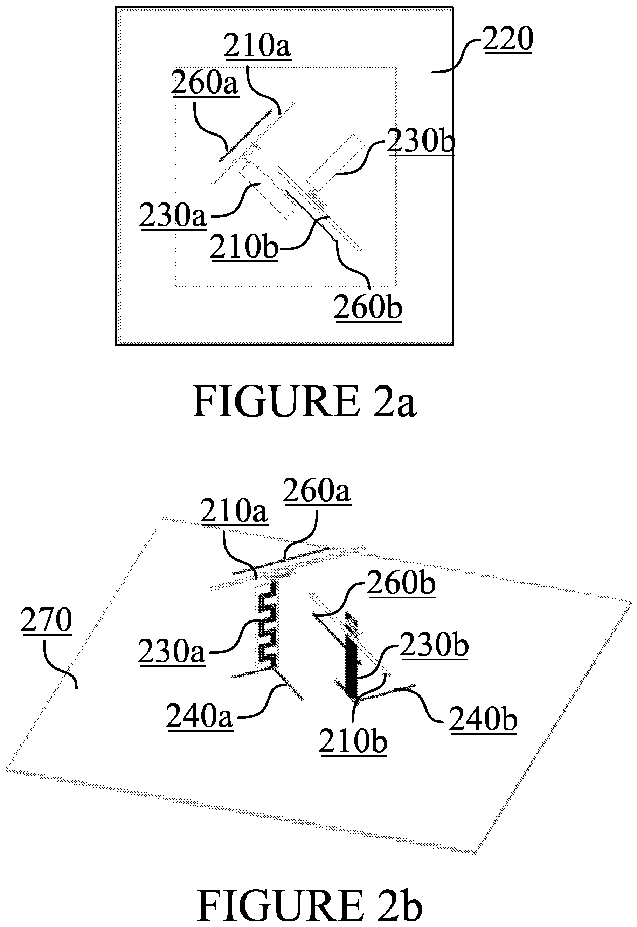

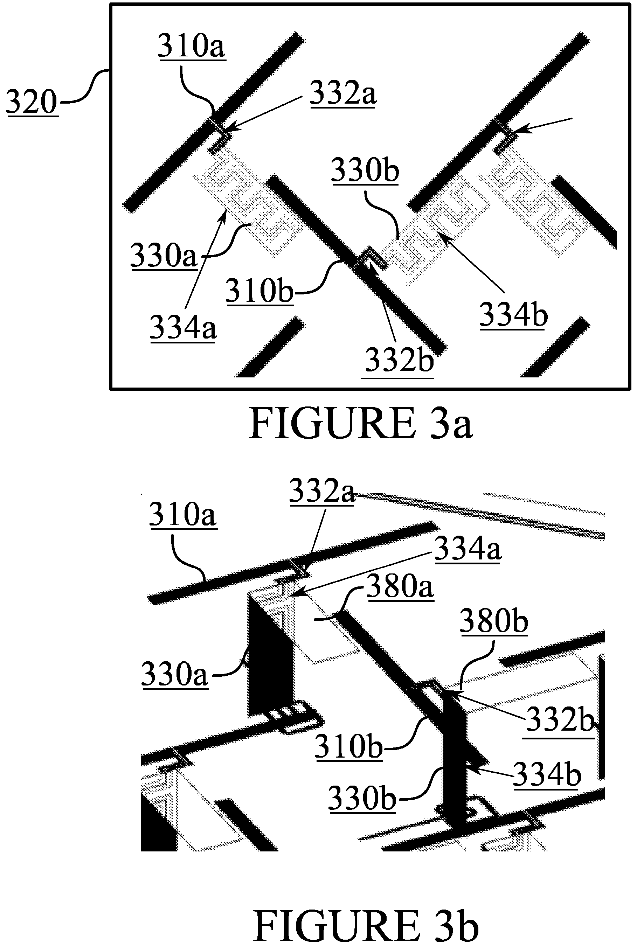

FIGUREs 2a and 2b, illustrate a first and a second example of two antenna elements in accordance with at least some embodiments of the present invention, respectively. In FIGUREs 2a and 2b, a first antenna is denoted by 210a and a second antenna is denoted by 210b while a first transmission line, connected or coupled to the first antenna 210a, is denoted by 230a and a second transmission line, connected or coupled to the second antenna 210b, is denoted by 230b. The first antenna 210a and the second antenna 210b may correspond to the antenna 210 of FIGURE 3 and the first transmission line 230a and the second transmission line 230b may correspond to the transmission line 130 of FIGURE 1. In addition, in FIGURE 2b a first feed 240a and a second feed 240b are shown. The first feed 240a and the second feed 240b may correspond to the feed 140 of FIGURE 1.

In FIGUREs 2a and 2b, a first parasitic element is denoted by 260a and a second parasitic element is denoted by 260b. The first parasitic element 260a and the second parasitic element 260b may correspond to the parasitic element 160 of FIGURE 1. Similarly as in case of the exemplary antenna element of FIGURE 1, the first parasitic element 260a and the second parasitic element 260b are optional, e.g., may be used in case of bandwidth enhancement or double band antennas.

As shown in FIGURE 2a, the first antenna 210a, the second antenna 210b, the first transmission line 230a and the second transmission line 230b may be on a single flexible film 220. The single flexible film 220 may correspond to the single flexible film 120 of FIGURE 1. FIGURE 2a depicts an example, wherein the transmission lines 230a and 230b may not be bent yet.

FIGURE 2b depicts an example, wherein a first part of the first transmission line 230a may be bent about 90 degrees compared to a second part of the first transmission line 230a. Similarly, a first part of the second transmission line 230a may be bent about 90 degrees compared to a second part of the second transmission line 230a. Therefore, the first transmission line 230a and the second transmission line 230b may be connected or coupled to the base board 270 of the antenna array after bending.

Final matching may be done at the base board 270 of the antenna array or in some cases directly attached to the transmission lines on the flexible film. Matching may be done using discrete components, such as inductors and capacitors, or distributed components, such as transmission lines, or as a combination of both. For instance, in some embodiments of the present invention, matching may be done using a single microstrip line stub printed (etched) perpendicular to the feed lines 140, 240 and 240b. Also, the feed line itself may be a part of a matching circuit. Embodiments of the present invention therefore enable simple and cost-effective manufacturing.

FIGUREs 3a and 3b, illustrate a third example and a fourth example of two antenna elements, respectively, in accordance with at least some embodiments of the present invention. The example of FIGURE 3a may be referred to as an example of a stamped antenna film, or sheet, and the example of FIGURE 3b may be referred to as an example of a bent antenna film, or sheet.

Similarly as in FIGUREs 2a and 2b, in FIGUREs 3a and 3b a first antenna is denoted by 310a and a second antenna is denoted by 310b while a first transmission line, connected or coupled to the first antenna 310a, is denoted by 330a and a second transmission line, connected or coupled to the second antenna 310b, is denoted by 330b. The first antenna 310a and the second antenna 310b may correspond to the antenna 110 of FIGURE 1 and the first transmission line 330a and the second transmission line 330b may correspond to the transmission line 130 of FIGURE 1. In FIGURE 3a a single flexible film 320 is also shown and the single flexible film may correspond to the single flexible film 120 of FIGURE 1. In addition, in FIGURE 3b a first opening 380a and a second opening 380b on a single flexible sheet are shown.

FIGURE 3a illustrates the first dipole antenna 310a, the second dipole antenna 310b, the first transmission line 330a and the second transmission line 330b on the single flexible film 320, i.e., sheet. The single flexible film 320 may be referred to as a stamped antenna sheet.

Then, FIGURE 3b illustrates the first antenna 310a, the second antenna 310b, the first transmission line 330a and the second transmission line 330b on the single flexible film 320, i.e., sheet, when a first part 332a of the first transmission line 330a is bent 90 degrees compared to a second part 334a of the first transmission line 330b. Also, a first part 332b of the second transmission line 330b is bent 90 degrees compared to a second part 334b of the second transmission line 330b. As shown in the example of FIGURE 3b, the single flexible film 310b may be bent and the first transmission line 330a is arranged to go through the first opening 380a while the second transmission line 330b is arranged to go through the second opening 380b.

That is to say, for example the first part 332a of the first transmission line 330a may be at the same level with the second part 334a of the first transmission line 330a before bending, i.e., as shown in the example of FIGURE 3a. Also, the first transmission line 330a may be at the same level with the antenna 310a before bending. However, after bending the first part of the first transmission line 330a may be perpendicular to the second part of the first transmission line 330a and to the antenna 310a, as shown in FIGURE 3b.

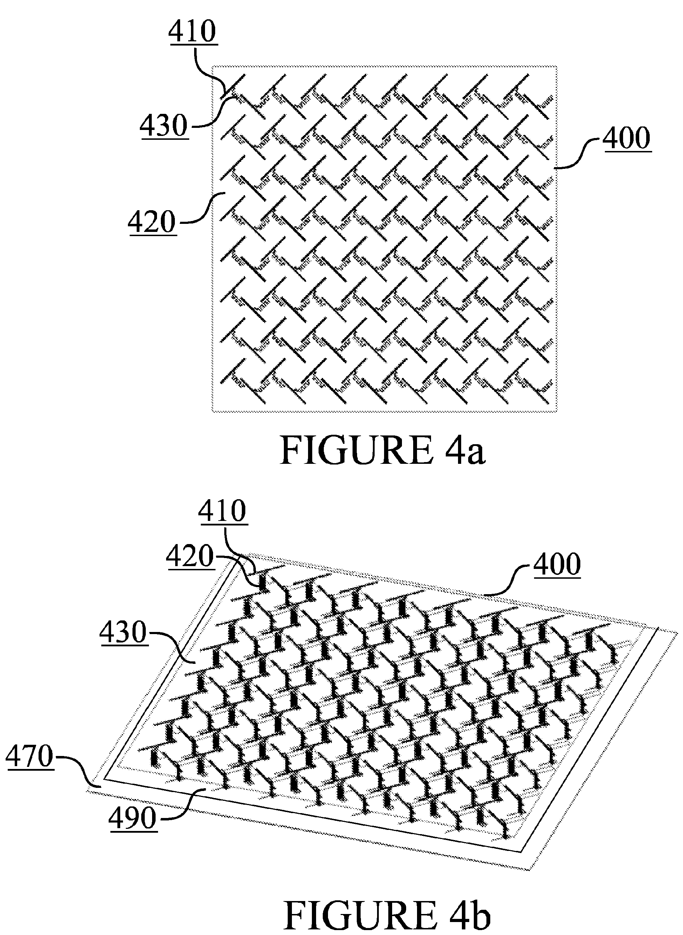

FIGUREs 4a and 4b illustrate a first and a second example of an antenna array comprising 8*8 antenna elements, respectively, in accordance with at least some embodiments of the present invention. Embodiments of the present invention may be in general exploited for antenna arrays comprising any number of antenna elements though. For instance, embodiments of the present invention may be exploited for antenna arrays comprising 128 antenna elements, e.g., for sub 6 GHz frequency bands, such as for single band 3.2 - 3.8 GHz and double band 3.3 - 5.0 GHz.

In FIGUREs 4a and 4b, the antenna array is denoted by 400, an antenna is denoted by 410, a single flexible film is denoted by 420 and a transmission line is denoted by 430. The antenna 410, the single flexible film 420 and the transmission line 430 may correspond to the antenna 110, the single flexible film 120 and the transmission line 130 of FIGURE 1. In FIGURE 4b a base board 470 is shown and the base board 470 may correspond to the base board 270 of FIGURE 2. In FIGURE 4b a spacer 490 is shown as well. The spacer 490 may be referred to as a support element in some embodiments. Moreover, the spacer 490 may be between the base board 470 and one or more antennas 410. In some embodiments, the spacer 490 may be needed to keep the single film 420, i.e., an antenna film in form. The spacer 490 may be printed with a 3D printer.

Embodiments of the present invention therefore provide an antenna element for an antenna array, wherein the antenna element may be made of cheap and light-weight material. Moreover, embodiments of the present invention provide an antenna element and an antenna array which are suitable for mass production. For example, conventional etching process may be exploited on a single flexible film if the single flexible film is copper plated. On the other hand, roll-to-roll silver plate printing may be exploited as well, if some metal losses can be tolerated.

Even though the essence of the present invention is in structural lightness, cheapness in production and suitability for mass production, one additional aspect is that the transmission line connecting the antenna element with a base board may be printed/etched as a pair line on the same side of the flexible sheet, i.e., film, as the antenna. Moreover, as the antenna-transmission-line pattern may be only at one side of the flexible sheet, no alignment of print is needed as in two- or multi-layer structures. The impedance level of such a transmission line may be high (~150 ohms), instead of more convenient ~50 ohms, but when the transmission line is half wavelength long, the antenna input impedance is close to the original. As distance *L* is about a quarter of the wavelength, the missing quarter may be accomplished by line meandering. Further, the line length may be tuned to make the rest of the antenna tuning on the base board, for example with transmission line stubs. The matching could in some cases be done on the antenna sheet.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to one embodiment or an embodiment means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment. Where reference is made to a numerical value using a term such as, for example, about or substantially, the exact numerical value is also disclosed.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the preceding description, numerous specific details are provided, such as examples of lengths and widths as electrical dimensions (i.e., as a function of a used wavelength), shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the scope of the present claims. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", that is, a singular form, throughout this document does not exclude a plurality.

### INDUSTRIAL APPLICABILITY

At least some embodiments of the present invention find industrial application in wireless communication networks. Examples of wireless communication networks comprise 5G/NR and WLAN networks. For example, an antenna element or an antenna array in accordance with at least some embodiments of the present invention suits particularly well for wireless communication networks wherein massive MIMO is used, e.g., in 5G BSs.

### ACRONYMS LIST

- 3GPP: 3rd Generation Partnership Project
- 5G: 5^{th} Generation
- LTE: Long Term Evolution
- MIMO: Multiple-Input Multiple-Output
- NR: New Radio
- PET: Polyethylene terephthalate
- RAT: Radio Access Technology
- RF: Radio Frequency
- UE: User Equipment
- WLAN: Wireless Local Area Network

### REFERENCE SIGNS LIST

| | |
|---|---|
| 100 | Antenna element |
| 110, 210, 310, 410 | Antenna, e.g., dipole antenna |
| 120, 220, 320, 420 | Single flexible film |
| 130, 230, 330, 430 | Transmission line |
| 132, 332 | First part of transmission line 130 |
| 134, 334 | Second part of transmission line 130 |
| 140, 240 | Feed |
| 150 | Support element |
| 160, 260 | Parasitic element |
| 270, 470 | Base board |
| 380 | Opening |
| 400 | Antenna array |
| 490 | Spacer |

## Claims

1. An antenna element (300) for an antenna array, comprising:
- a transmission line (330), a single flexible film (320), an antenna (310) and a base board, wherein one end of the transmission line (330) is coupled to the base board of the antenna array and another end of the transmission line (330) is coupled to the antenna (310), and a first part (332) of the transmission line (330) is bent about 90 degrees compared to a second part (334) of the transmission line (330), and the transmission line (330) and the antenna (310) are on, or in, the single flexible film (320), **characterized in that**
- the single flexible film (320) comprises an opening (380), wherein the second part (334) of the transmission line (330) is arranged to go through the opening (380), and the opening is a hole.

2. An antenna element (300) according to claim 1, further comprising at least a part of a support element (150) between the base board of the antenna array and the antenna (310), wherein the transmission line (330) is bent along a side of the part of the support element (150).

3. An antenna element (300) according to claim 1 or claim 2, wherein said single flexible film (320) is made of plastic.

4. An antenna element (300) according to any of the preceding claims, wherein the single flexible film (320) is made of Polyethylene terephthalate, PET, -material.

5. An antenna element (300) according to any of the preceding claims, wherein a thickness of the single flexible film (320) is about 50 micrometers or less, such as 25 micrometers.

6. An antenna element (300) according to any of the preceding claims, wherein the antenna (310) is a dipole antenna.

7. An antenna element (300) according to any of the preceding claims, wherein the antenna (310) and the base board are at a distance from each other, the distance preferably being comparable to a quarter of a wavelength.

8. An antenna element (300) according to any of the preceding claims, wherein the transmission line (330) comprises copper or silver paste.

9. An antenna element (300) according to any of the preceding claims, wherein the antenna element (300) further comprises a parasitic element (160) in parallel with the antenna (310).

10. An antenna array comprising multiple antenna elements (300) according to any of the preceding claims.

11. A wireless network node comprising the antenna array according to claim 10.

12. A wireless network node according to claim 11, wherein the wireless network node is a base station configured to operate in accordance with a 3rd Generation Partnership Project, 3GPP, standard.

13. A wireless network node according to claim 12, wherein the 3GPP standard is a 5G standard.

## Patentansprüche

1. Antennenelement (300) für ein Antennenarray, umfassend:
- eine Übertragungsleitung (330), eine einzelne flexible Folie (320), eine Antenne (310) und eine Grundplatte, wobei ein Ende der Übertragungsleitung (330) mit der Grundplatte des Antennenarrays gekoppelt ist und ein anderes Ende der Übertragungsleitung (330) mit der Antenne (310) gekoppelt ist, und ein erster Teil (332) der Übertragungsleitung (330) um etwa 90 Grad im Vergleich zu einem zweiten Teil (334) der Übertragungsleitung (330) gebogen ist, und die Übertragungsleitung (330) und die Antenne (310) auf oder in der einzelnen flexiblen Folie (320) sind, **dadurch gekennzeichnet, dass**
- die einzelne flexible Folie (320) eine Öffnung (380) umfasst, wobei der zweite Teil (334) der Übertragungsleitung (330) so angeordnet ist, dass er durch die Öffnung (380) geht, und die Öffnung ein Loch ist.

2. Antennenelement (300) nach Anspruch 1, weiter umfassend mindestens einen Teil eines Trägerelements (150) zwischen der Grundplatte des Antennenarrays und der Antenne (310), wobei die Übertragungsleitung (330) entlang einer Seite des Teils des Trägerelements (150) gebogen ist.

3. Antennenelement (300) nach Anspruch 1 oder Anspruch 2, wobei die einzelne flexible Folie (320) aus Kunststoff hergestellt ist.

4. Antennenelement (300) nach einem der vorstehenden Ansprüche, wobei die einzelne flexible Folie (320) aus Polyethylenterephthalat, PET, -Material hergestellt ist.

5. Antennenelement (300) nach einem der vorstehenden Ansprüche, wobei eine Dicke der einzelnen flexiblen Folie (320) etwa 50 Mikrometer oder weniger, wie zum Beispiel 25 Mikrometer, beträgt.

6. Antennenelement (300) nach einem der vorstehenden Ansprüche, wobei die Antenne (310) eine Dipolantenne ist.

7. Antennenelement (300) nach einem der vorstehenden Ansprüche, wobei die Antenne (310) und die Grundplatte voneinander beabstandet sind, wobei der Abstand vorzugsweise mit einem Viertel einer Wellenlänge vergleichbar ist.

8. Antennenelement (300) nach einem der vorstehenden Ansprüche, wobei die Übertragungsleitung (330) Kupfer- oder Silberpaste umfasst.

9. Antennenelement (300) nach einem der vorstehenden Ansprüche, wobei das Antennenelement (300) weiter ein parasitäres Element (160) parallel zu der Antenne (310) umfasst.

10. Antennenarray, umfassend mehrere Antennenelemente (300) nach einem der vorstehenden Ansprüche.

11. Drahtloser Netzwerkknoten, umfassend das Antennenarray nach Anspruch 10.

12. Drahtloser Netzwerkknoten nach Anspruch 11, wobei der drahtlose Netzwerkknoten eine Basisstation ist, die für den Betrieb gemäß einem Standard des 3rd Generation Partnership Project, 3GPP, konfiguriert ist.

13. Drahtloser Netzwerkknoten nach Anspruch 12, wobei der 3GPP-Standard ein 5G-Standard ist.

## Revendications

1. Élément d'antenne (300) pour un réseau d'antennes, comprenant :
- une ligne de transmission (330), un film flexible unique (320), une antenne (310) et une plaque de base, dans lequel une certaine extrémité de la ligne de transmission (330) est couplée à la plaque de base du réseau d'antennes et une autre extrémité de la ligne de transmission (330) est couplée à l'antenne (310), et une première partie (332) de la ligne de transmission (330) est fléchie sur environ 90 degrés par comparaison à une seconde partie (334) de la ligne de transmission (330), et la ligne de transmission (330) et l'antenne (310) sont sur ou dans le film flexible unique (320), **caractérisé en ce que**
- le film flexible unique (320) comprend une ouverture (380), dans lequel la seconde partie (334) de la ligne de transmission (330) est agencée pour passer à travers l'ouverture (380), et l'ouverture est un trou.

2. Élément d'antenne (300) selon la revendication 1, comprenant en outre au moins une partie d'un élément de support (150) entre la plaque de base du réseau d'antennes et l'antenne (310), dans lequel la ligne de transmission (330) est fléchie le long d'un côté de la partie de l'élément de support (150).

3. Élément d'antenne (300) selon la revendication 1 ou la revendication 2, dans lequel ledit film flexible unique (320) est réalisé en plastique.

4. Élément d'antenne (300) selon l'une quelconque des revendications précédentes, dans lequel le film flexible unique (320) est réalisé en un matériau de polyéthylène téréphtalate, PET.

5. Élément d'antenne (300) selon l'une quelconque des revendications précédentes, dans lequel une épaisseur du film flexible unique (320) est d'environ 50 micromètres ou moins, comme 25 micromètres.

6. Élément d'antenne (300) selon l'une quelconque des revendications précédentes, dans lequel l'antenne (310) est une antenne dipôle.

7. Élément d'antenne (300) selon l'une quelconque des revendications précédentes, dans lequel l'antenne (310) et la plaque de base sont à une certaine distance l'une de l'autre, la distance étant de préférence comparable à un quart d'une longueur d'onde.

8. Élément d'antenne (300) selon l'une quelconque des revendications précédentes, dans lequel la ligne de transmission (330) comprend une pâte de cuivre ou d'argent.

9. Élément d'antenne (300) selon l'une quelconque des revendications précédentes, dans lequel l'élément d'antenne (300) comprend en outre un élément parasite (160) en parallèle avec l'antenne (310).

10. Réseau d'antennes comprenant plusieurs éléments d'antenne (300) selon l'une quelconque des revendications précédentes.

11. Nœud de réseau sans fil comprenant le réseau d'antennes selon la revendication 10.

12. Nœud de réseau sans fil selon la revendication 11, dans lequel le nœud de réseau sans fil est une station de base configurée pour fonctionner conformément à une norme de projet de partenariat de 3e génération, 3GPP.

13. Nœud de réseau sans fil selon la revendication 12, dans lequel la norme 3GPP est une norme 5G.
